# EUROPÄISCHE PATENTANMELDUNG

(11) **EP 4 756 069 A1**
(43) Veröffentlichungstag der Anmeldung: **10.06.2026**
(21) Anmeldenummer: 24217905.9
(22) Anmeldetag: 05.12.2024
(51) Int. Cl.: C23C 14/04, C23C 14/24, C23C 14/14, C23C 14/56, B41F 19/00

(54) **APPLIKATIONSVORRICHTUNG, BESCHICHTUNGSANLAGE, VERFAHREN ZUM BEDAMPFEN EINER FOLIE MIT METALLDAMPF ZUR AUSBILDUNG VON METALLISCHEN SCHICHTEN IN EINER BESCHICHTUNGSANLAGE, WICKELKONDENSATOR UND VERWENDUNG EINER TRANSFERWALZE**

(71) Anmelder: Bühler Alzenau GmbH, 63755 Alzenau (DE)
(72) Erfinder: MÜCKE, Michael, 63755 Alzenau (DE); HAGEMANN, Heiko, 63755 Alzenau (DE)
(74) Vertreter: Prinz & Partner mbB

(57) **Zusammenfassung**

Es wird eine Applikationsvorrichtung (18) für eine Beschichtungsanlage (10) zum Bedampfen von Folien mit Metalldampf zur Ausbildung einer metallischen Schicht angegeben, wobei die Applikationsvorrichtung (18) eine Vakuumkammer (34) aufweist und eingerichtet ist, ein Maskierungsfluid auf die zu bedampfende Folie in der Vakuumkammer (34) aufzubringen, wobei die Applikationsvorrichtung (18) eine Transferwalze (26) und eine Druckwalze (28) umfasst, die in der Vakuumkammer (34) angeordnet sind, wobei auf der Druckwalze (28) eine mit der Transferwalze (26) in Kontakt stehende Druckform (30) angeordnet ist. Die Applikationsvorrichtung (18) umfasst einen Verdampfer (32) für das Maskierungsfluid, der eingerichtet ist, einen Maskierungsfluiddampf zu erzeugen. Die Applikationsvorrichtung (18) weist ein dem Verdampfer (32) zugeordnetes Maskierungsfluiddampf-Dosiersystem (42) auf, das der Transferwalze (26) zugewandt und eingerichtet ist, die Menge des Maskierungsfluiddampfs quer zur Längsachse der Transferwalze (26) unterschiedlich zu dosieren, sodass sich auf der Transferwalze (26) lokal unterschiedlich dicke Schichten des Maskierungsfluids absetzen. Des Weiteren werden eine Beschichtungsanlage (10), ein Verfahren zum Bedampfen einer Folie, ein Wickelkondensator und die Verwendung einer Transferwalze (26) angegeben.

## Beschreibung

Die Erfindung betrifft eine Applikationsvorrichtung, insbesondere eine Rollenrotationsdruckvorrichtung, für eine Beschichtungsanlage zum Bedampfen von Folien mit Metalldampf zur Ausbildung einer metallischen Schicht, sowie eine Beschichtungsanlage mit einer Applikationsvorrichtung und ein Verfahren zum Bedampfen einer Folie mit Metalldampf zur Ausbildung von metallischen Schichten in einer Beschichtungsanlage. Des Weiteren betrifft die Erfindung einen Wickelkondensator, der durch Aufwickeln einer beschichteten Folienbahn gebildet ist. Zudem betrifft die Erfindung die Verwendung einer Transferwalze in einer Beschichtungsanlage.

Vor dem Bedampfen einer Folie mit Metalldampf zur Ausbildung einer metallischen Schicht wird mittels der Applikationsvorrichtung ein Maskierungsfluid, beispielsweise Öl, auf die Folie aufgebracht, und zwar in den Bereichen, die nach dem Bedampfen frei von einer metallischen Schicht sein sollen. Genauer gesagt soll sich dort, wo das Maskierungsfluid aufgebracht ist, kein Metall absetzen. In den übrigen Bereichen setzt sich Metall durch Kondensation ab. Während des Bedampfungsprozesses verdampft das Maskierungsfluid, sodass nach Abschluss des Bedampfungsprozesses im Idealfall kein Maskierungsfluid mehr auf der Folie vorhanden ist.

Die Folien werden nach dem Beschichtungsprozess zu elektronischen Bauteilen weiterverarbeitet, zum Beispiel zu einem eingangs erwähnten Wickelkondensator.

Die Menge des auf die Folie aufgebrachten Maskierungsfluids muss dabei sehr genau dosiert werden. Ist die Menge des aufgebrachten Maskierungsfluids in einem Bereich zu gering, können sich metallische Ablagerungen auch in den Bereichen bilden, die eigentlich frei von Metall sein sollen. Derartige metallische Verunreinigungen können die Qualität des aus der beschichteten Folie hergestellten elektronischen Bauteils beinträchtigen. Wird jedoch zu viel Maskierungsfluid aufgetragen, verdampft das Maskierungsfluid bis zum Abschluss des Bedampfungsprozesses nicht vollständig und die auf der Folie verbleibenden Reste des Maskierungsfluids können die nachgelagerten Fertigungsprozesse negativ beeinflussen. Insbesondere kann sich Maskierungsfluid in Form von Tröpfchen von der Folie lösen, welche sich unkontrolliert in der Anlage bzw. auf der Folie verteilen können. Wenn diese Tröpfchen auf einen Bereich der Folie auftreffen, in dem eine metallische Schicht gebildet werden soll, verursachen die Tröpfchen unerwünschte Aussparungen in der metallischen Schicht, was wiederum das herzustellende elektronische Bauteil beeinträchtigen kann.

Besonders herausfordernd ist dies, wenn die aufzubringende metallische Schicht unterschiedlich dicke Bereiche haben soll.

Es ist daher eine Aufgabe der vorliegenden Erfindung, eine in Bezug auf die Fertigungsqualität verbesserte Applikationsvorrichtung für eine Beschichtungsanlage zum Bedampfen von Folien mit Metalldampf zur Ausbildung einer metallischen Schicht sowie eine entsprechende Beschichtungsanlage bereitzustellen. Des Weiteren ist es eine Aufgabe der Erfindung, ein verbessertes Verfahren zum Bedampfen einer Folie mit Metalldampf zur Ausbildung von metallischen Schichten in einer Beschichtungsanlage anzugeben.

Diese Aufgabe wird erfindungsgemäß gelöst durch eine Applikationsvorrichtung, insbesondere eine Rollenrotationsdruckvorrichtung, für eine Beschichtungsanlage zum Bedampfen von Folien mit Metalldampf zur Ausbildung einer metallischen Schicht. Die Applikationsvorrichtung weist eine Vakuumkammer auf und ist eingerichtet, ein Maskierungsfluid, beispielsweise ein Öl, auf die zu bedampfende Folie in der Vakuumkammer aufzubringen.

Die Applikationsvorrichtung umfasst eine Transferwalze und eine Druckwalze, die in der Vakuumkammer angeordnet sind, wobei auf der Druckwalze eine mit der Transferwalze in Kontakt stehende Druckform angeordnet ist. Des Weiteren umfasst die Applikationsvorrichtung einen Verdampfer für das Maskierungsfluid, der eingerichtet ist, einen Maskierungsfluiddampf zu erzeugen, wobei die Applikationsvorrichtung ein dem Verdampfer zugeordnetes Maskierungsfluiddampf-Dosiersystem aufweist, das der Transferwalze zugewandt und eingerichtet ist, die Menge des Maskierungsfluiddampfs quer zur Längsachse der Transferwalze unterschiedlich zu dosieren, sodass sich auf der Transferwalze lokal unterschiedlich dicke Schichten des Maskierungsfluids absetzen.

Die erfindungsgemäße Applikationsvorrichtung hat den Vorteil, dass das auf eine Folie aufgebrachte Maskierungsfluid lokal unterschiedlich dick aufgebracht werden kann. In anderen Worten hat der von der Druckwalze auf die Folie übertragene Abdruck des Maskierungsfluids Bereiche mit unterschiedlicher Schichtdicke. Hierdurch wird gewährleistet, dass in den Bereichen, in denen eine vermehrte Metallkondensation stattfindet und somit dickere metallische Schichten gebildet werden, keine vollständige Verdampfung des Maskierungsfluids vor Ende des Beschichtungsprozesses auftritt, wodurch unerwünschte metallische Ablagerungen vermieden werden. In den Bereichen, in denen eine geringere Metallkondensation stattfindet und die metallische Schicht eine geringere Schichtdicke hat, verbleiben keine übermäßigen Reste des Maskierungsfluids an der Folie. Dadurch wird vermieden, dass sich Spritzer des Maskierungsfluids von der Folie ablösen.

Das Maskierungsfluid lässt sich unter Vakuum verdampfen und verdampft auf der Folie aufgrund seiner Restwärme, wobei der Verdampfungsprozess durch das Vakuum in der Vakuumkammer unterstützt wird. Insofern hat das verwendete Maskierungsfluid eine auf die beim Bedampfungsprozess mit dem Metall vorliegenden Bedingungen entsprechend eingestellte Siedetemperatur, um zu gewährleisten, dass das Maskierungsfluid auf der Folie verdampft.

Das Maskierungsfluid hat zudem dielektrische Eigenschaften.

Die Viskosität des Maskierungsfluids ist derart gewählt, dass das Maskierungsfluid auf der Folie nicht verläuft, sich jedoch gut von der Transferwalze auf die Druckwalze und von dieser auf die Folie übertragen lässt.

Das Maskierungsfluid hat beispielsweise eine kinematische Viskosität von 11 bis 18 cSt bei 40° und von 2 bis 4 cSt bei 100°.

Die Druckform ist beispielsweise austauschbar, insbesondere als eine Hülle ("sleeve") ausgebildet, die auf einen Grundkörper der Druckwalze angeordnet werden kann. Somit können mit der Applikationsvorrichtung unterschiedliche Maskierungsfluid-Abdrücke auf der Folie abgebildet werden, sodass durch das Maskierungsfluid unterschiedliche transparente Strukturen gebildet werden können, woraus unterschiedliche metallische Strukturen resultieren.

Gemäß einem Aspekt ist die Dosierung des Maskierungsfluiddampf-Dosiersystems auf das Druckprofil der Druckform abgestimmt. Das Druckprofil entspricht dem gewünschten Abdruck des Maskierungsfluids auf der zu bedampfenden Folie. Konkret findet in den Bereichen eine höhere Dosierung des Maskierungsfluiddampfes statt, die von der Druckform in einen Bereich auf der Folie übertragen werden, in dem eine vermehrte Metallkondensation stattfinden soll.

Beispielsweise weist das Druckprofil mindestens eine erste Struktur, die einem verstärkten Randbereich einer Folienbahn entspricht, und mindestens eine zweite Struktur, die einem aktiven Bereich einer Folienbahn entspricht, auf. Das Maskierungsfluiddampf-Dosiersystem ist insbesondere derart auf das Druckprofil abgestimmt, dass im Bereich der ersten Struktur eine höhere Dosierung des Maskierungsfluiddampfes erfolgt als im Bereich der zweiten Struktur. Grundsätzlich lässt sich über die Strukturen des Druckprofils also die Menge des Maskierungsfluiddampfs einstellen, die aufgenommen wird.

Das Maskierungsfluiddampf-Dosiersystem kann eine Maske sein, die zumindest eine entlang der Transferwalze verlaufende Öffnung hat, deren Breite entlang der Transferwalze variiert, oder die Maske kann mehrere Öffnungen haben, von denen zumindest zwei Öffnungen eine unterschiedliche Breite haben. Die Breite der Öffnung bzw. der mehreren Öffnungen erstreckt sich zumindest in eine Richtung quer zur Längsachse der Transferwalze bzw. quer zur Längsachse der Maske.

Beispielsweise hat die Maske eine Vielzahl von rechteckigen, kreisrunden, elliptischen oder anders geformten Öffnungen. Im Falle einer kreisrunden oder elliptischen Öffnung entspricht die Breite dem Kreisdurchmesser bzw. je nach Orientierung der Ellipse der Haupt- oder Nebenachse der Ellipse.

Durch die variierende Breite der durchgehenden Öffnung bzw. der einzelnen Öffnungen in der Maske wird die Menge des auf die Transferwalze aufgebrachten Maskierungsfluids eingestellt bzw. gesteuert, das heißt die Menge des Maskierungsfluids lässt sich lokal unterschiedlich dosieren. Je breiter die Öffnung ist, umso mehr Maskierungsfluid kann im entsprechenden Bereich in einem definierten Zeitraum entweichen und umso dicker ist die Schicht des Maskierungsfluids, die sich an der Transferwalze absetzt, insbesondere kondensiert. Die Dosierung erfolgt somit basierend auf einer Öffnungsgeometrie der Maske.

Insgesamt betrachtet lässt sich die Menge des zu dosierenden Maskierungsfluids durch die Verdampfungstemperatur des Maskierungsfluids steuern, das heißt, je höher die Temperatur des Maskierungsfluids ist, umso mehr Maskierungsfluid entweicht in einem definierten Zeitraum aus dem Verdampfer. Dadurch lässt sich jedoch keine lokal unterschiedliche Dosierung des Maskierungsfluids erreichen. Dies erfolgt wie vorhergehend beschrieben durch die Maskierungsfluid-Dosiereinrichtung.

Die Maske kann eine separat von dem Verdampfer ausgebildete, streifenförmige Platte sein. Eine derartige Maske lässt sich besonders einfach herstellen, beispielsweise als Stanzteil.

Die Maske ist beispielsweise aus einem Metall gefertigt, es sind jedoch auch andere Materialien denkbar.

Gemäß einem Aspekt ist die Maske an einer Austrittsöffnung des Verdampfers lösbar befestigt, beispielsweise verschraubt. Dadurch ist ein einfacher Austausch der Maske möglich, beispielsweise beim Umrüsten der Beschichtungsanlage für einen neuen Fertigungsauftrag. Das Maskierungsfluiddampf-Dosiersystem lässt sich somit schnell und kostengünstig wechseln, sodass dies auf einen anderen Fertigungsauftrag der zu bedampfenden Folie abgestimmt ist, insbesondere auf die dazugehörige Druckform.

Der Maskierungsfluiddampf soll nur durch die vorgesehenen Öffnungen der Maske entweichen. Um dies sicherzustellen, kann zwischen der Maske und dem Verdampfer eine Abdichtung vorhanden sein, beispielsweise in Form einer Flachdichtung.

Gemäß einer Ausführungsform hat die Öffnung der Maske mindestens einen kreuzförmigen Ausschnitt, ausgehend von dem sich in Längsrichtung der Öffnung beidseitig Verbindungsabschnitte erstrecken, die eine geringere Breite haben als der kreuzförmige Abschnitt. Beispielsweise beträgt die Breite der Verbindungsabschnitte ein Viertel der maximalen Breite des kreuzförmigen Ausschnitts. Die Öffnung ist in diesem Fall entlang der Maske durchgehend gestaltet.

Anstelle einer Maske ist denkbar, dass das Maskierungsfluiddampf-Dosiersystem mehrere in Längsrichtung der Transferwalze nebeneinander angeordnete Düsen aufweist, die jeweils eine unterschiedliche Menge des Maskierungsfluids abgeben. Auf diese Weise kann ebenfalls eine in Längsrichtung der Transferwalze unterschiedliche Dosierung des Maskierungsfluids erreicht werden. Der durch die jeweiligen Düsen strömende Fluidstrom lässt sich steuern, insbesondere individuell für jede der Düsen, um so die Menge des Maskierungsfluiddampfs quer zur Längsachse der Transferwalze unterschiedlich zu dosieren, also das Dosieren des Maskierungsfluiddampfs zu ermöglichen. Hierzu kann der Querschnitt des Fluidstroms des Maskierungsfluiddampfs und/oder ein zeitliches Mittel der Menge des Maskierungsfluiddampfs gesteuert werden, beispielweise bei einer pulsierenden Ansteuerung der Düsen.

An der Außenfläche der Transferwalze kann ein Keramikmaterial vorgesehen sein. Insbesondere ist auf der Umfangsfläche der Transferwalze eine keramische Beschichtung aufgebracht, beispielsweise auf einem Kernkörper, oder auf einem nicht-keramischen Kernkörper der Transferwalze ist eine keramische Hülse angeordnet. Durch die keramische Außenfläche erfolgt eine bessere Anhaftung und Übertragung des Maskierungsfluids, wodurch die Temperatur im Verdampfer und somit die Temperatur des Maskierungsfluiddampfs reduziert werden kann. Dies wirkt sich positiv auf die Fertigungsqualität aus. Genauer gesagt wird durch die reduzierte Temperatur des Maskierungsfluids die thermische Belastung der Folie verringert, wodurch eine Faltenbildung der Folie vermieden wird.

Das an der Außenfläche der Transferwalze angeordnete Keramikmaterial ist insbesondere an seiner Oberfläche geschliffen. Dadurch hat die Oberfläche der Transferwalze beispielsweise eine Rauigkeit Rz von 1,0 bis 1,5 µm.

Die Transferwalze ist an ihrer Außenfläche insbesondere frei von gezielt eingebrachten Strukturen, insbesondere Vertiefungen.

Durch die keramische, insbesondere geschliffene Oberfläche ist die Transferwalze in der Lage, die erforderliche Menge des Maskierungsfluids aufzunehmen und auf die Druckwalze zu übertragen. Mit anderen Worten ist die Aufnahme und Abgabe von Maskierungsfluid auf bzw. von der Transferwalze besonders effizient.

Konkret ist durch die keramische Oberfläche der Transferwalze das Aufnahmekapazität der Transferwalze im Vergleich zu den bisher bekannten Transferwalzen mit gelaserter Oberfläche signifikant reduziert, insbesondere um mindestens ein Drittel. Das heißt, dass die Transferwalze mit geschliffener Oberfläche weniger Maskierungsfluid aufnimmt als beispielsweise eine Transferwalze mit gelaserter Oberfläche. Insofern ist die Oberfläche der Transferwalze eine nicht-gelaserte Oberfläche, da es eine geschliffene Oberfläche ist. Beispielsweise beträgt der Bedarf an Maskierungsfluid weniger als 1 cm³/m² bezogen auf die Fläche der Folienbahn. Demnach lässt sich der Verbrauch an Maskierungsfluid durch die Transferwalze mit keramischer Oberfläche deutlich reduzieren, wodurch Kosten eingespart werden können.

Auch die Übertragung des Maskierungsfluids auf die Druckwalze erfolgt mit einer Transferwalze mit keramischer Oberfläche im Vergleich zu einer Transferwalze mit gelaserter Oberfläche auf besonders effiziente Art und Weise. Bei gelaserten Transferwalzen sind üblicherweise Vertiefungen, beispielsweise in Form von Waben, stumpfen Pyramiden, Diamanten, Haschuren und/oder Gegenhaschuren, vorhanden, in denen das Maskierungsfluid aufgenommen ist.

Bei einer Transferwalze mit einer wie vorhergehend beschriebenen keramischen Oberfläche sind keine derartigen Vertiefungen vorhanden, wodurch ein deutlich geringerer Anpressdruck zwischen der Transferwalze und der Druckwalze erforderlich ist, was sich vorteilhaft auf die Lebensdauer der Transferwalze sowie der Druckwalze bzw. einer auf der Druckwalze angeordneten Druckform auswirkt.

Die Aufnahmekapazität der Transferwalze wird auch durch die Drehgeschwindigkeit der Transferwalze beeinflusst. Die Drehgeschwindigkeit der Transferwalze beträgt beispielsweise zwischen 20 und 50 Umdrehungen pro Minute. Die Vorschubgeschwindigkeit der Folienbahn in der Beschichtungsanlage beträgt in diesem Fall zwischen 8 m/s und 14 m/s.

Gemäß einem Aspekt stehen die Transferwalze und die Druckwalze in Kontakt und ein zwischen der Transferwalze und der Druckwalze herrschender Druck ist mittels zumindest eines Servomotors variabel einstellbar. Dies trägt zu einer Verbesserung der Druckqualität bei, da hierdurch die Übertragung des Maskierungsfluids von der Transferwalze auf die Druckwalze eingestellt werden kann.

Die Aufgabe wird des Weiteren erfindungsgemäß gelöst durch eine Beschichtungsanlage zum Bedampfen von Folien mit Metalldampf zur Ausbildung einer metallischen Schicht, mit einer wie vorhergehend beschriebenen Applikationsvorrichtung, einer Fördereinrichtung zum Fördern einer Folienbahn durch die Vakuumkammer und einer Bedampfungseinrichtung zum Bedampfen der Folie mit Metalldampf zur Ausbildung von metallischen Schichten, die in der Vakuumkammer angeordnet ist.

Neben den bereits in Zusammenhang mit der Applikationsvorrichtung beschriebenen Vorteilen können durch die Anordnung der Bedampfungseinrichtung in der Vakuumkammer die metallischen Dämpfe ohne Luftwiderstand auf die Folie treffen, was zu einer gleichmäßigen Schichtdicke führt. Insbesondere kann die Beschichtung der Folie mit einer hohen Präzision erfolgen. Zudem bildet die Vakuumkammer einen abgeschlossenen Raum, wodurch Verunreinigungen der Folie während des Beschichtungsprozesses vermieden werden.

Die Transferwalze, die Druckwalze und der Verdampfer können zum Wechseln der Maske und der Druckform aus der Vakuumkammer entnommen, insbesondere herausgefahren werden. Hierzu können die Transferwalze, die Druckwalze und der Verdampfer auf einem gemeinsamen Träger angeordnet sein, der entnehmbar ist, um somit gleichzeitig die Transferwalze, die Druckwalze und den Verdampfer entnehmen zu können. Der Träger kann verfahrbar sein.

Die Aufgabe wird des Weiteren erfindungsgemäß gelöst durch ein Verfahren zum Bedampfen einer Folie mit Metalldampf zur Ausbildung von metallischen Schichten in einer Beschichtungsanlage, beispielsweise in einer wie vorhergehend beschriebenen Beschichtungsanlage.

In einem ersten Verfahrensschritt wird in einem Verdampfer ein Maskierungsfluid erhitzt, wodurch ein Maskierungsfluiddampf erzeugt wird, der sich an einer Transferwalze innerhalb einer Vakuumkammer absetzt, während die Transferwalze rotiert, wobei die Menge des Maskierungsfluiddampfs entlang der Längsachse der Transferwalze unterschiedlich dosiert wird, sodass sich auf der Transferwalze lokal unterschiedlich dicke Schichten des Maskierungsfluids absetzen. Die unterschiedliche Dosierung des Maskierungsfluiddampfs entlang der Längsachse der Transferwalze wird beispielsweise durch eine erfindungsgemäße Applikationsvorrichtung erreicht.

In einem nachfolgenden Verfahrensschritt wird die Schicht des Maskierungsfluids von der Transferwalze zunächst auf eine mit der Transferwalze in Kontakt stehende und rotierende Druckwalze und in der Vakuumkammer von der Druckwalze entsprechend einem durch eine auf der Druckwalze vorgesehene Druckform definierten Druckmuster auf eine durch die Vakuumkammer der Beschichtungsanlage laufende Folienbahn übertragen, wobei sich auf der Folienbahn entsprechend der Dosierung zumindest ein erster Bereich und ein zweiter Bereich ergibt, wobei die Schicht des Maskierungsfluids im ersten Bereich dünner ist als im zweiten Bereich.

In dem ersten Bereich und in dem zweiten Bereich wird jeweils zumindest eine metallische Schicht durch Bedampfen in der Vakuumkammer aufgebracht, wobei die metallische Schicht in dem ersten Bereich dünner ist als in dem zweiten Bereich.

Die Schicht des Maskierungsfluids ist in einem Bereich in dem Moment vollständig oder nahezu vollständig verdampft, in dem die metallische Schicht in dem entsprechenden Bereich vollständig aufgebracht ist. Dies wird insbesondere dadurch erreicht, dass das Maskierungsfluid in dem entsprechenden Bereich eine definierte Schichtdicke hat.

Das durch Bedampfen aufgebrachte Metall haftet nur an den Stellen, an denen kein Maskierungsfluid, insbesondere kein Öl, vorhanden ist. Anders ausgedrückt stellt das Maskierungsfluid einen Negativabdruck der nachfolgend aufgebrachten metallischen Schicht dar. Da die Schicht des Maskierungsfluids kontinuierlich verdampft, insbesondere aufgrund der Kondensationsenergie des aufgebrachten Metalldampfes sowie der Bestrahlungsenergie der Bedampfungseinrichtung, ist in den Bereichen, in denen eine dickere metallische Schicht aufgebracht werden soll und folglich die Beschichtung länger dauert, eine dickere Schicht des Maskierungsfluids notwendig, um Ablagerungen in dem mit Maskierungsfluid bedruckten Bereich zu vermeiden. Die Restwärme des Maskierungsfluids und das Vakuum können ebenfalls zur Verdampfung des Maskierungsfluid beitragen.

Gemäß einem Aspekt ist die Dicke der Schicht des Maskierungsfluids genau auf die Dicke der aufzubringenden metallischen Schicht abgestimmt.

Der erste Bereich und der zweite Bereich verlaufen in Transportrichtung der Folienbahn beispielsweise parallel zueinander.

In Sinne der Anmeldung bedeutet "nahezu vollständig verdampft", dass nur derart geringe Reste des Maskierungsfluids vorhanden sein dürfen, die keine Spritzer verursachen können und sich somit nicht nachteilig auf die nachgelagerten Fertigungsschritte auswirken.

Der erzeugte Maskierungsfluiddampf kann durch eine Maske entweichen, die der Austrittsöffnung des Verdampfers zugeordnet ist, insbesondere wobei sich in den Bereichen, in denen die entlang der Transferwalze verlaufende Öffnung der Maske eine größere Breite hat, eine dickere Schicht des Maskierungsfluids auf der Transferwalze absetzt, als in den Bereichen, in denen die Öffnung der Maske eine geringere Breite hat. Mittels einer Maske kann eine Dosierung des Maskierungsfluids entlang der Transferwalze auf besonders einfache Weise erfolgen. Insbesondere erfolgt die variierende Dosierung auf passive Art und Weise, also ohne dass eine komplexe Regelung notwendig ist. Lediglich die im Verdampfer eingestellte Temperatur des Maskierungsfluiddampfes hat einen zusätzlichen Einfluss auf die Dosierung.

Gemäß einer Ausführungsform ist das Maskierungsfluid ein Öl, insbesondere ein PFPE-ÖI. Ein derartiges Öl ist aufgrund seines Dampfdrucks und seiner Viskosität besonders gut als Maskierungsfluid geeignet.

Die erste metallische Schicht und die zweite metallische Schicht können ineinander übergehen. Dadurch ist eine elektrisch leitende Verbindung zwischen den beiden metallischen Schichten geschaffen.

Die metallische Schicht kann im zweiten Bereich einen verstärkten Randbereich auf einer Folienbahn abbilden. Man spricht in diesem Fall auch von einem heavy-edge-Bereich. Ein derart verstärkter Randbereich dient zur Verbesserung der elektrischen Eigenschaften. Insbesondere hat die metallische Schicht im verstärkten Randbereich einen im Vergleich zu den übrigen Bereichen der metallischen Schicht niedrigen elektrischer Widerstand, was zu einer niedrigeren Verlustleistung sowie einer verringerten Temperatur im entsprechenden Bereich führt, wodurch sich Lebensdauer des elektronischen Bauteils entsprechend verlängern lässt. Der verstärkte Randbereich eignet sich beispielswiese zum Ausbilden von Anschlusskontakten, also zum elektrischen Anschließen.

Die metallische Schicht kann in dem ersten Bereich voneinander getrennte Felder aufweisen, die jeweils durch einen Steg miteinander verbunden sind. Der Steg ist beispielsweise 0,1 mm bis 1 mm breit. Das Maskierungsfluid wird in diesem Bereich in Form von aneinander angrenzenden, nicht ausgefüllten Konturen aufgetragen, wobei in jeder Begrenzungslinie einer Kontur eine durchgehende Aussparung vorhanden ist, die später den Steg bildet. Der Steg dient als Schmelzleiter bzw. als Sicherung, insbesondere in Form einer Schmelzsicherung, um eine Durchschlagsenergie zu minimieren. Dadurch wird vermieden, dass im Fehlerfall das gesamte Bauteil ausfällt.

Die Aufgabe wird des Weiteren erfindungsgemäß gelöst durch einen Wickelkondensator, der durch Aufwickeln einer gemäß einem erfindungsgemäßen Verfahren beschichteten Folienbahn gebildet ist, wobei die metallische Schicht im ersten Bereich einen aktiven Bereich des Kondensators bildet und die metallische Schicht im zweiten Bereich einen elektrischen Anschluss bildet. Ein derartiger, mittels des erfindungsgemäßen Verfahrens hergestellter Wickelkondensator zeichnet sich durch besonders präzise abgebildete elektrische Strukturen aus, wobei Bereiche außerhalb der elektrischen Strukturen (weitestgehend) frei von unerwünschten metallischen Ablagerungen sind.

Die Aufgabe wird des Weiteren erfindungsgemäß gelöst durch die Verwendung einer Transferwalze in einer Beschichtungsanlage, wobei die Transferwalze eine keramische Oberfläche hat, die geschliffen ist, sodass die Transferwalze eine Rauigkeit Rz von 1,0 bis 1,5 µm hat. Wie bereits vorhergehend beschrieben, hat eine derartige Transferwalze eine optimierte Aufnahmekapazität.

Die Beschichtungsanlage, in der die Transferwalze verwendet wird, umfasst zumindest eine Applikationsvorrichtung, die eine Vakuumkammer aufweist und eingerichtet ist, ein Maskierungsfluid, beispielsweise ein Öl, auf die zu bedampfende Folie in der Vakuumkammer aufzubringen. Die Applikationsvorrichtung weist zudem einen Verdampfer für das Maskierungsfluid auf, der eingerichtet ist, einen Maskierungsfluiddampf zu erzeugen, der sich auf der Transferwalze absetzt. Die Applikationsvorrichtung umfasst eine Druckwalze, die in der Vakuumkammer angeordnet ist, wobei auf der Druckwalze eine mit der Transferwalze in Kontakt stehende Druckform angeordnet ist. Die Beschichtungsanlage umfasst zudem eine Fördereinrichtung zum Fördern einer Folienbahn durch eine Vakuumkammer der Applikationsvorrichtung und eine Bedampfungseinrichtung, die zum Bedampfen der Folie mit Metalldampf zur Ausbildung von metallischen Schichten vorgesehen ist, die in der Vakuumkammer angeordnet ist. Insbesondere wird die Transferwalze in einer Beschichtungsanlage der zuvor genannten Art bzw. in der Applikationsvorrichtung der zuvor genannten Art verwendet.

Weitere Vorteile und Merkmale der Erfindung ergeben sich aus der nachfolgenden Beschreibung und aus den beiliegenden Zeichnungen, auf die Bezug genommen wird. In den Zeichnungen zeigen:
- Figur 1 schematisch eine erfindungsgemäße Beschichtungsanlage mit einer erfindungsgemäßen Applikationsvorrichtung,
- Figur 2 einen Verdampfer zum Verdampfen von Maskierungsfluid,
- Figur 3 eine Detailansicht des Verdampfers,
- Figur 4 ein Maskierungsfluid-Dosiersystem in Form einer Maske,
- Figur 5 eine Detailansicht einer Öffnung der Maske aus Figur 4,
- Figur 6 schematisch einen Ausschnitt einer alternativen Maske,
- Figur 7 einen alternativen Verdampfer mit einem integrierten Maskierungsfluid-Dosiersystem,
- Figur 8 einen Querschnitt durch eine Transferwalze,
- Figur 9 schematisch einen Querschnitt einer Folie mit einem Maskierungsfluid,
- Figur 10 schematisch einen Querschnitt einer Folie mit einer metallischen Schicht,
- Figur 11 eine Folie mit einer metallischen Schicht, und
- Figur 12 schematisch einen Teilbereich der Folie aus Figur 11.

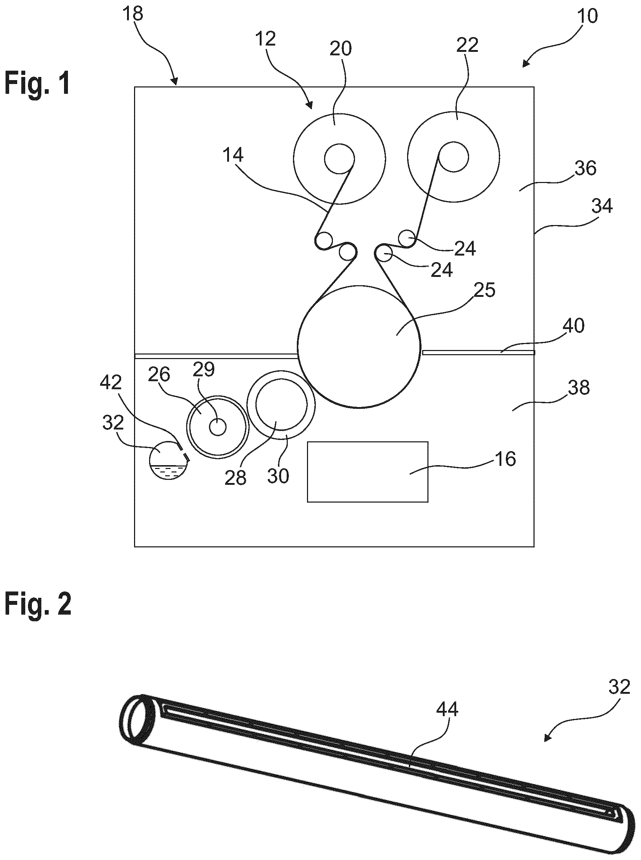

Figur 1 zeigt schematisch eine Beschichtungsanlage 10 zum Bedampfen von Folien mit Metalldampf zur Ausbildung einer metallischen Schicht.

Die Beschichtungsanlage 10 umfasst eine Fördereinrichtung 12 zum Fördern einer Folienbahn 14 durch die Beschichtungsanlage 10, eine Bedampfungseinrichtung 16 zum Bedampfen der Folien mit Metalldampf zur Ausbildung von metallischen Schichten sowie eine Applikationsvorrichtung 18, bei der es sich im Ausführungsbeispiel um eine Rollenrotationsdruckvorrichtung, beispielsweise um eine Flexodruckeinrichtung handelt.

Die Fördereinrichtung 12 umfasst eine Abwickelrolle 20 sowie eine Aufwickelrolle 22 und in Laufrichtung der Folienbahn 14 zwischen der Abwickelrolle 20 und der Aufwickelrolle 22 angeordnete Förder- und Umlenkrollen 24 sowie einen Hauptzylinder 25.

Die Applikationsvorrichtung 18 ist eingerichtet, ein Maskierungsfluid auf die Folienbahn 14 zu übertragen, und umfasst eine Transferwalze 26 und eine Druckwalze 28, auf der eine mit der Transferwalze 26 in Kontakt stehende Druckform 30 angeordnet ist.

Der zwischen der Transferwalze 26 und der Druckwalze 28 herrschende Druck lässt sich mittels zumindest eines Servomotors 29 variabel einstellen. Beispielsweise sind zwei Servomotoren zur Einstellung eines Drucks zwischen der Transferwalze 26 und der Druckwalze 28 vorhanden.

Die Einstellung eines Drucks zwischen der Druckwalze 28 und dem Hauptzylinder 25 kann ebenfalls mittels eines oder mehrerer Servomotoren erfolgen, die aus Gründen der besseren Übersichtlichkeit aber nicht dargestellt sind.

Zudem weist die Applikationsvorrichtung 18 einen Verdampfer 32 für das Maskierungsfluid auf, der eingerichtet ist, einen Maskierungsfluiddampf zu erzeugen. Zu diesem Zweck umfasst der Verdampfer 32 eine Heizeinrichtung, die in den Figuren jedoch der Einfachheit halber nicht dargestellt ist.

Die Applikationsvorrichtung 18 umfasst außerdem eine Vakuumkammer 34.

In der Vakuumkammer 34 sind die Transferwalze 26, die Druckwalze 28 und der Verdampfer 32 angeordnet, insbesondere dann, wenn die entsprechenden Bauteile in einer Betriebsposition sind. Zum Umrüsten der Beschichtungsanlage 10 lassen sich die Transferwalze 26, die Druckwalze 28 und der Verdampfer 32 aus der Vakuumkammer 34 entnehmen, beispielsweise herausfahren.

Die Bedampfungseinrichtung 16 der Beschichtungsanlage 10 ist ebenfalls in der Vakuumkammer 34 angeordnet, sodass diese im Vakuum betrieben wird.

Außerdem ist im gezeigten Ausführungsbeispiel die Fördereinrichtung 12 ebenfalls in der Vakuumkammer 34 angeordnet, da die Fördereinrichtung 12 die Folienbahn 14 durch die Vakuumkammer 34 fördert. Es ist jedoch auch denkbar, dass Teile der Fördereinrichtung 12 außerhalb der Vakuumkammer 34 angeordnet sind.

Im Ausführungsbeispiel gemäß Figur 1 ist die Vakuumkammer 34 in zwei Bereiche 36, 38 unterteilt, die strömungsmäßig voneinander getrennt sind, wobei die Applikationsvorrichtung 18 und die Bedampfungseinrichtung 16 im zweiten Bereich 38 angeordnet ist. Durch die Unterteilung der Vakuumkammer 34 in zwei Bereiche ist die Verteilung eines durch die Bedampfungseinrichtung 16 erzeugten Metalldampfes begrenzt.

Die Fördereinrichtung 12 ist weitestgehend im ersten Bereich 36 angeordnet, wobei der Hauptzylinder 25 der Fördereinrichtung 12 in den zweiten Bereich 38 hineinragt, um ein Niederschlagen des von der Bedampfungseinrichtung 16 erzeugten Metalldampfes auf der Folienbahn 14 zu ermöglichen.

Die Bereiche 36, 38 sind beispielsweise durch eine Trennwand 40 voneinander getrennt.

Dem Verdampfer 32 ist ein Maskierungsfluiddampf-Dosiersystem 42 zugeordnet.

Das Maskierungsfluiddampf-Dosiersystem 42 ist der Transferwalze 26 zugewandt und eingerichtet, die Menge des aus dem Verdampfer 32 entweichenden Maskierungsfluiddampfes quer zur Längsachse der Transferwalze 26 unterschiedlich zu dosieren, sodass sich auf der Transferwalze 26 lokal unterschiedlich dicke Schichten des Maskierungsfluids absetzen.

Dadurch hat die von der Druckwalze 28 auf der Folienbahn 14 übertragene Maskierungsfluidschicht eine variierende Dicke, was nachfolgend noch im Detail beschrieben wird.

Die Dosierung des Maskierungsfluiddampf-Dosiersystems 42 ist auf das Druckprofil der Druckform 30 abgestimmt. Damit ist gemeint, dass in den Bereichen, in denen die Druckform 30 eine Struktur aufweist, die eine dickere Maskierungsfluidschicht erfordert, als in anderen Bereichen, eine höhere Dosierung des Maskierungsfluiddampfes durch das Maskierungsfluiddampf-Dosiersystem 42 erfolgt.

In Figur 2 ist ein beispielhafter Verdampfer 32 gezeigt, der im Ausführungsbeispiel rohrförmig ist.

Die seitlichen Rohrenden sind durch Endkappen abgedichtet, die der Einfachheit halber nicht dargestellt sind.

Entlang der Längsachse des Verdampfers 32 erstreckt sich eine (durchgehende) Austrittsöffnung 44, durch die der Maskierungsfluiddampf entweichen kann.

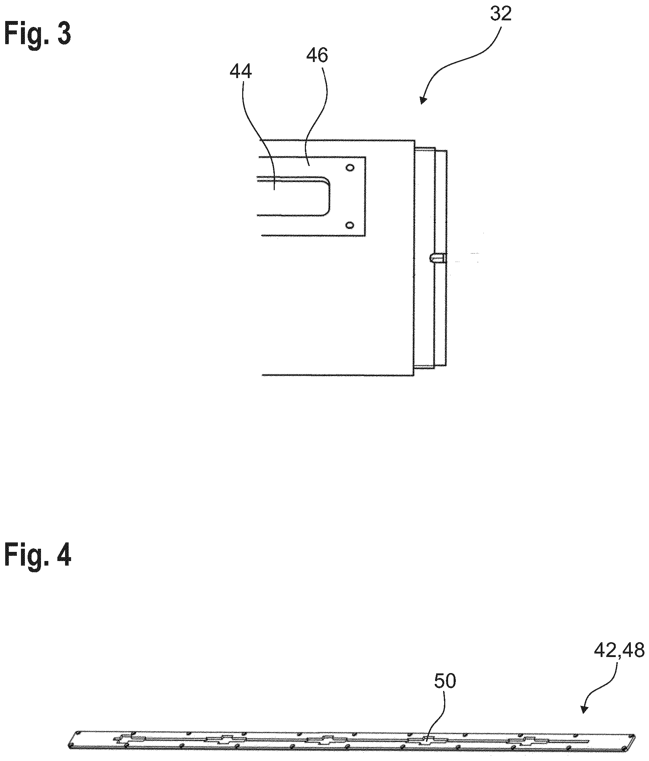

Die Austrittsöffnung 44 ist von einer umlaufenden Anlagefläche 46 für das Maskierungsfluiddampf-Dosiersystem 42 umgeben, wie es in Figur 3 zu sehen ist, die einen Teilbereich der Anlagefläche 46 zeigt.

Die Anlagefläche 46 ist eine ebene Fläche, wobei innerhalb der Anlagefläche 46 mehrere Schraublöcher zur Befestigung des Maskierungsfluiddampf-Dosiersystems 42 vorhanden sind.

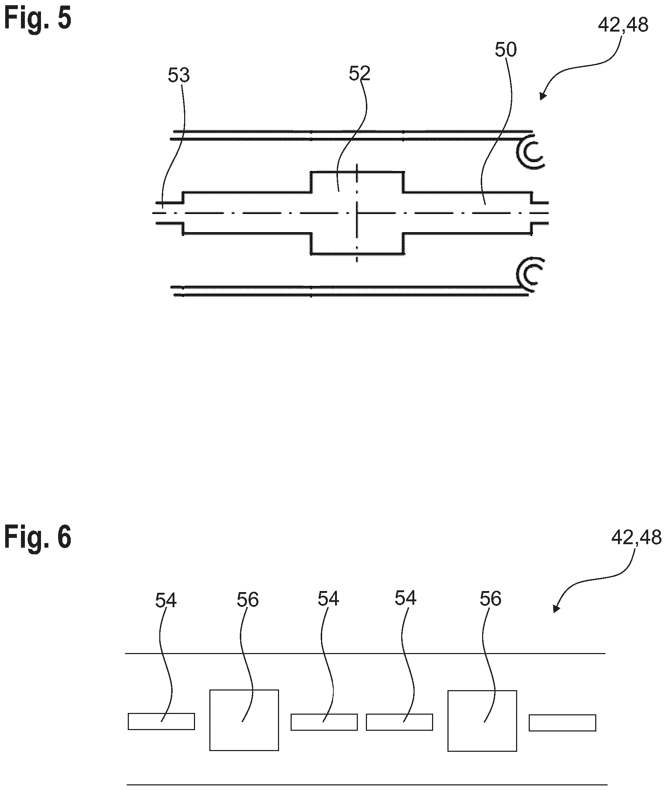

Die Figuren 4 und 5 veranschaulichen ein Maskierungsfluiddampf-Dosiersystem 42 gemäß einer ersten Ausführungsform.

Das in Figur 4 veranschaulichte Maskierungsfluiddampf-Dosiersystem 42 ist eine Maske 48, die sich an dem Verdampfer 32, genauer gesagt an der Anlagefläche 46, lösbar befestigen lässt.

Konkret ist die Maske 48 im Ausführungsbeispiel gemäß den Figuren 4 und 5 eine separat vom Verdampfer 32 ausgebildete, streifenförmige Platte.

Im Ausführungsbeispiel lässt sich die Maske 48 an der Anlagefläche 46 verschrauben, es sind jedoch auch andere Befestigungsmöglichkeiten denkbar.

Wenn die Maske 48 an dem Verdampfer 32 befestigt ist, ist die Maske an der Austrittsöffnung 44 des Verdampfers 32 angeordnet und deckt diese teilweise ab.

Die Maske 48 hat eine Öffnung 50, die, wenn der Verdampfer 32 mit der Maske 48 in der Applikationsvorrichtung 18 montiert ist, entlang der Transferwalze 26 verläuft.

Zwischen der Maske 48 und der Anlagefläche 46 ist beispielsweise eine Flachdichtung vorhanden, über die sichergestellt ist, dass der Maskierungsfluiddampf den Verdampfer 32 nur in definierter Weise verlässt, nämlich über die Öffnung 50.

Die Breite der Öffnung 50 variiert entlang der Transferwalze 26, wie es besonders gut in Figur 5 zu sehen ist, welche einen sich wiederholenden Teilabschnitt der Öffnung 50 zeigt.

Die in Figur 5 veranschaulichte Öffnung 50 hat mehrere kreuzförmige Abschnitte 52. Ausgehend von den kreuzförmigen Abschnitten 52 erstrecken sich beidseitig Verbindungsabschnitte 53. Somit variiert die Breite der Öffnung 50 zwischen drei unterschiedlichen diskreten Werten.

In einer alternativen Ausführungsform, die der Einfachheit halber nicht gezeigt ist, können statt kreuzförmiger Abschnitte rechteckige Abschnitte vorhanden sein. Die Breite der Öffnung 50 würde dann zwischen zwei diskreten Werten variieren.

In Figur 6 ist schematisch ein Ausschnitt einer alternativen Maske 48 veranschaulicht.

Die Maske 48 gemäß Figur 6 unterscheidet sich von der in den Figuren 4 und 5 veranschaulichten Maske 48 dadurch, dass nicht eine durchgehende Öffnung 50 vorgesehen ist, sondern, dass die Maske 48 mehrere voneinander getrennte Öffnungen 54, 56 aufweist, die sich zum Teil in ihrer Form unterscheiden. Mit anderen Worten sind diskrete Öffnungen 54, 56 vorgesehen, wobei zumindest zwei unterschiedliche Größen vorgesehen sind.

Konkret sind erste rechteckige Öffnungen 54 und zweite rechteckige Öffnungen 56 vorhanden, die sich in ihrer Breite unterscheiden. Optional können weitere Öffnungen mit einer dritten Breite vorhanden sein.

Statt rechteckiger Öffnungen können auch kreisrunde, elliptische, hexagonale oder anders geformte Öffnungen vorhanden sein.

Die Figuren 2 bis 6 veranschaulichen jeweils eine Ausführungsform des Verdampfers 32 bzw. der Maske 48, bei der die Maske 48 separat vom Verdampfer 32 ausgebildet und lösbar an diesem befestigt ist.

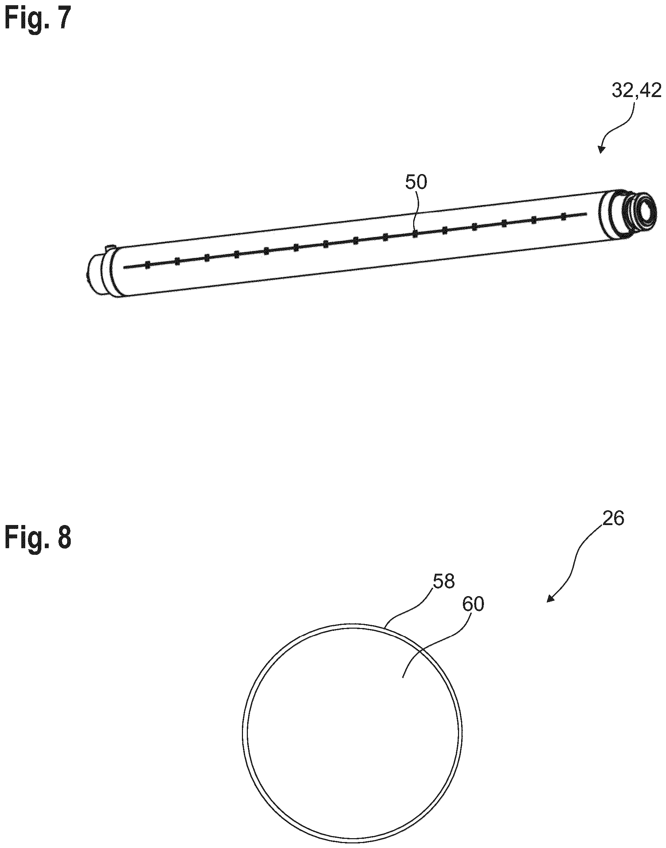

Figur 7 veranschaulicht eine alternative Ausführungsform des Verdampfers 32, bei dem das Maskierungsfluiddampf-Dosiersystem 42, genauer gesagt die Maske 48, integral im Verdampfer 32 ausgebildet ist.

Die Ausführungsformen gemäß den Figuren 2 bis 6 mit einer separat vom Verdampfer 32 ausgebildeten Maske haben jedoch gegenüber der in Figur 7 veranschaulichten Ausführungsform den Vorteil, dass bei einem Austausch der Maske 48 der Verdampfer 32 selbst nicht ausgetauscht werden muss, sondern nur die Maske 48.

Dies kann insbesondere dann notwendig sein, wenn ein anderes Druckprofil auf der Folie gewünscht ist, was mit einem Austausch der Druckform 30 einhergeht. Typischerweise sind die Druckform 30 und das Maskierungsfluiddampf-Dosiersystem 42, insbesondere die Maske 48, aufeinander abgestimmt, sodass sie gemeinsam gewechselt werden, um zu gewährleisten, dass der Maskierungsfluiddampf in gewünschter Weise auf die Transferwalze 26 aufgebracht wird, sodass dies mit dem Druckprofil der Druckform 30 zusammenpasst.

Figur 8 zeigt einen Querschnitt durch eine Transferwalze 26.

Auf der Außenfläche der Transferwalze 26 ist ein Keramikmaterial 58 vorhanden, das beispielsweise in Form einer keramischen Beschichtung auf einen Kernkörper 60 aufgebracht ist oder als Hülse auf den Kernkörper 60 aufgeschoben ist.

Die Außenfläche der Transferwalze 26 ist dabei frei von einer Lasergravur.

Die keramische Außenfläche der Transferwalze 26 ist stattdessen geschliffen und hat beispielsweise eine Rauigkeit Rz von 1,0 bis 1,5 µm.

Der Kernkörper 60 ist aus einem nicht-keramischen Material gebildet, beispielsweise aus Stahl.

Unter Bezugnahme auf die Figuren 1 bis 10 wird im Folgenden ein Verfahren zum Bedampfen einer Folie mit Metalldampf zur Ausbildung von metallischen Schichten in einer Beschichtungsanlage 10 beschrieben.

Zunächst wird das Maskierungsfluid im Verdampfer 32 erhitzt, wodurch ein Maskierungsfluiddampf erzeugt wird, der durch die Austrittsöffnung 44 des Verdampfers 32 entweicht und sich innerhalb der Vakuumkammer 34 an der Transferwalze 26 absetzt, während die Transferwalze 26 rotiert. Dadurch wird die Transferwalze 26 umfangsmäßig gleichmäßig mit dem Maskierungsfluid bedeckt.

Die Menge des Maskierungsfluiddampfs wird entlang der Längsachse der Transferwalze 26 unterschiedlich dosiert, sodass sich auf der Transferwalze 26 lokal unterschiedlich dicke Schichten des Maskierungsfluids absetzen. Dieser Vorgang findet ebenfalls in der Vakuumkammer 34 statt, also unter Vakuumbedingungen.

Die unterschiedliche Dosierung erfolgt im Ausführungsbeispiel mittels der Maske 48, die der Austrittsöffnung 44 des Verdampfers 32 zugeordnet ist und durch die der Maskierungsfluiddampf entweicht.

Genauer gesagt erfolgt die unterschiedliche Dosierung aufgrund der variierenden Breite der Öffnung 50. Dort, wo die Öffnung 50 eine größere Breite hat, kann im selben Zeitraum eine größere Menge des Maskierungsfluiddampfes aus dem Verdampfer 32 entweichen und sich auf der Transferwalze 26 niederschlagen, was in einer größeren Schichtdicke des Maskierungsfluids auf der Transferwalze 26 resultiert.

Das gleiche Prinzip gilt auch für die in Figur 6 dargestellte Maske 48 mit mehreren einzelnen Öffnungen.

Bei dem Maskierungsfluid handelt es sich beispielsweise um ein PFPE-ÖI.

Die Schicht des Maskierungsfluids wird ebenfalls in der Vakuumkammer 34 von der Transferwalze 26 zunächst auf die mit der Transferwalze 26 in Kontakt stehende und rotierende Druckwalze 28 und von der Druckwalze 28 entsprechend einem durch die auf der Druckwalze 28 vorgesehene Druckform 30 definierten Druckmuster auf die durch die Vakuumkammer 34 der Beschichtungsanlage 10 laufende Folienbahn 14 übertragen.

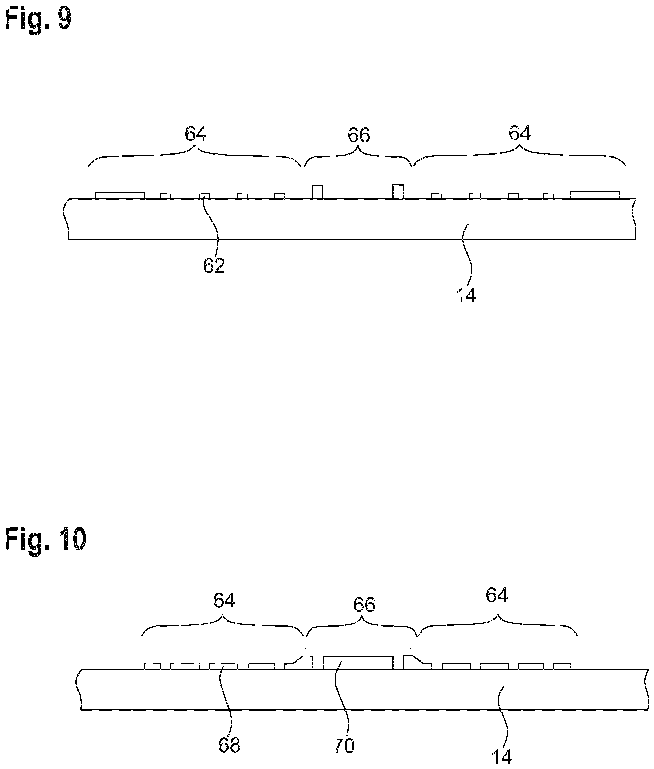

Ein schematischer Querschnitt eines Ausschnitts einer Folienbahn 14, auf der eine Schicht 62 des Maskierungsfluids aufgebracht ist, ist schematisch in Figur 9 zu sehen.

Entsprechend der Dosierung des Maskierungsfluids ergibt sich auf der Folienbahn 14 zumindest ein erster Bereich 64 und ein zweiter Bereich 66, wobei die Schicht 62 des Maskierungsfluids im ersten Bereich 64 dünner ist als im zweiten Bereich 66.

Die Schicht 62 muss nicht zwangsweise zusammenhängend sein, sondern kann auch voneinander getrennte Abschnitte sowie Aussparungen haben, also diskrete Bereiche abdecken. Konkret stellt die Schicht 62 einen Negativabdruck einer nachfolgend aufgebrachten metallischen Schicht dar, was aus der nachfolgenden Beschreibung noch deutlich wird.

Durch die Fördereinrichtung 12 wird der mit dem Maskierungsfluid versehene Folienabschnitt der Folienbahn 14 von der Applikationsvorrichtung 18, insbesondere von der Druckwalze 28, zur Bedampfungseinrichtung 16 befördert.

Durch die Bedampfungseinrichtung 16 wird ein Metalldampf erzeugt, der sich auf der Folienbahn 14 absetzt, und zwar nur in den Bereichen, in denen kein Maskierungsfluid vorhanden ist, um dort eine metallische Schicht zu bilden.

Bei dem Metalldampf handelt es sich beispielsweise um einen Dampf aus Aluminium, Zink und Silber, wobei Aluminium und Zink den Hauptbestandteil des Dampfes ausmachen.

Während des Bedampfungsvorgangs verdampft das Maskierungsfluid von der Folienbahn 14, insbesondere aufgrund der Kondensationsenergie des aufgebrachten Metalldampfes sowie der Bestrahlungsenergie der Bedampfungseinrichtung. Da die Schicht 62 des Maskierungsfluids im zweiten Bereich 66 aufgrund der größeren Schichtstärke länger braucht, um zu verdampfen, als im ersten Bereich 64, kann im zweiten Bereich 66 für einen längeren Zeitraum Metall aufgedampft werden und es entsteht folglich im zweiten Bereich 66 eine dickere metallische Schicht als im ersten Bereich 64.

Die Dosierung des Maskierungsfluids und die entsprechende Schichtstärke der Schicht 62 auf der Folienbahn 14 ist derart gewählt, dass die Schicht 62 des Maskierungsfluids in einem Bereich 64, 66 in dem Moment vollständig oder nahezu vollständig verdampft ist, in dem die metallische Schicht in dem entsprechenden Bereich 64, 66 vollständig aufgebracht ist.

Somit ist nach Abschluss des Beschichtungsvorgangs lediglich eine metallische Schicht auf der Folienbahn 14 vorhanden, aber kein Maskierungsfluid.

Eine Menge des auf der Transferwalze 26 abgesetzten Maskierungsfluids lässt sich beispielsweise durch die Verdampfungstemperatur des Verdampfers 32 sowie die Rotationsgeschwindigkeit der Transferwalze 26 regulieren. Je höher die Temperatur im Verdampfer 32 ist, umso größer ist die Menge des in einem definierten Zeitraum verdampften Maskierungsfluids. Je langsamer die Transferwalze 26 rotiert, umso mehr Maskierungsfluid kann sich auf der Transferwalze absetzen.

In Figur 10 ist schematisch eine Folienbahn 14 nach Abschluss des Beschichtungsverfahrens mit einer metallischen Schicht veranschaulicht, insbesondere mit einer ersten metallischen Schicht 68 in dem ersten Bereich 64 und einer zweiten metallischen Schicht 70 in dem zweiten Bereich 66.

Die erste metallische Schicht 68 und die zweite metallische Schicht 70 gehen im Ausführungsbeispiel ineinander über.

Im zweiten Bereich 66 bildet die metallische Schicht 70 einen verstärkten Randbereich.

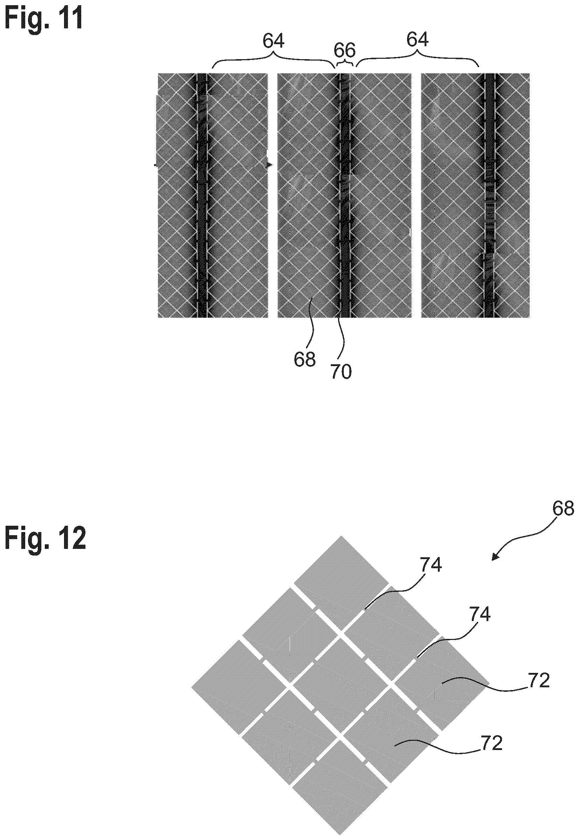

Figur 11 zeigt eine mit einer metallischen Schicht 68, 70 versehende Folienbahn 14.

Die beschichtete Folienbahn 14 wird üblicherweise mittig in den freiliegenden Bereichen sowie mittig im Bereich der zweiten metallischen Schicht 70 getrennt, also mittig im sogenannten heavy-edge Bereich.

Figur 12 zeigt schematisch einen vergrößerten Bereich der metallischen Schicht 68 im ersten Bereich 64.

Die metallische Schicht 68 weist in dem ersten Bereich 64 voneinander getrennte Felder 72 auf. Diese sind im Ausführungsbeispiel rechteckig, insbesondere quadratisch. Es sind jedoch auch andere Strukturen denkbar, beispielsweise in Form eines Parallelogramms.

Die Felder 72 sind jeweils durch einen Steg 74 miteinander verbunden.

Die Stege 74 sind beispielsweise 0,1 mm bis 1 mm breit und bilden einen Schmelzleiter bzw. eine Sicherung, um eine Durchschlagsenergie zu reduzieren.

Das Maskierungsfluid wird in diesem Bereich in Form von aneinander angrenzenden, nicht ausgefüllten Rechtecken aufgetragen, wobei in jeder Begrenzungslinie eine durchgehende Aussparung vorhanden ist, die später den Steg 74 bildet. Das heißt, wie bereits vorhergehend erläutert, bildet das Maskierungsfluid ein Negativ der metallischen Schicht 68, 70.

Aus der in Figur 11 dargestellten Folienbahn 14 lässt sich durch aufwickeln ein Wickelkondensator bilden. Dabei bildet die metallische Schicht 68 im ersten Bereich 64 einen aktiven Bereich des Kondensators und die metallische Schicht 70 im zweiten Bereich 66 bildet einen elektrischen Anschluss.

## Patentansprüche

1. Applikationsvorrichtung (18), insbesondere Rollenrotationsdruckvorrichtung, für eine Beschichtungsanlage (10) zum Bedampfen von Folien mit Metalldampf zur Ausbildung einer metallischen Schicht (68, 70), wobei die Applikationsvorrichtung (18) eine Vakuumkammer (34) aufweist und eingerichtet ist, ein Maskierungsfluid, beispielsweise ein Öl, auf die zu bedampfende Folie in der Vakuumkammer (34) aufzubringen,
wobei die Applikationsvorrichtung (18) eine Transferwalze (26) und eine Druckwalze (28) umfasst, die in der Vakuumkammer (34) angeordnet sind, wobei auf der Druckwalze (28) eine mit der Transferwalze (26) in Kontakt stehende Druckform (30) angeordnet ist,
wobei die Applikationsvorrichtung (18) einen Verdampfer (32) für das Maskierungsfluid umfasst, der eingerichtet ist, einen Maskierungsfluiddampf zu erzeugen, und
wobei die Applikationsvorrichtung (18) ein dem Verdampfer (32) zugeordnetes Maskierungsfluiddampf-Dosiersystem (42) aufweist, das der Transferwalze (26) zugewandt und eingerichtet ist, die Menge des Maskierungsfluiddampfs quer zur Längsachse der Transferwalze (26) unterschiedlich zu dosieren, sodass sich auf der Transferwalze (26) lokal unterschiedlich dicke Schichten des Maskierungsfluids absetzen.

2. Applikationsvorrichtung (18) nach Anspruch 1, **dadurch gekennzeichnet, dass** die Dosierung des Maskierungsfluiddampf-Dosiersystems (42) auf das Druckprofil der Druckform (30) abgestimmt ist.

3. Applikationsvorrichtung (18) nach Anspruch 1 oder 2, **dadurch gekennzeichnet, dass** das Maskierungsfluiddampf-Dosiersystem (42) eine Maske (48) ist, die zumindest eine entlang der Transferwalze (26) verlaufende Öffnung (50), deren Breite entlang der Transferwalze (26) variiert, oder mehrere Öffnungen (54, 56), von denen zumindest zwei Öffnungen (54, 56) eine unterschiedliche Breite haben, hat.

4. Applikationsvorrichtung (18) nach Anspruch 3, **dadurch gekennzeichnet, dass** die Maske (48) eine separat von dem Verdampfer (32) ausgebildete, streifenförmige Platte ist.

5. Applikationsvorrichtung (18) nach Anspruch 3 oder 4, **dadurch gekennzeichnet, dass** die Maske (48) an einer Austrittsöffnung (44) des Verdampfers (32) lösbar befestigt ist, beispielsweise verschraubt ist.

6. Applikationsvorrichtung (18) nach einem der vorhergehenden Ansprüche, **dadurch gekennzeichnet, dass** an der Außenfläche der Transferwalze (26) ein Keramikmaterial (58) vorgesehen ist, insbesondere wobei auf der Umfangsfläche der Transferwalze (26) eine keramische Beschichtung aufgebracht ist, beispielsweise auf einem Kernkörper (60), oder wobei auf einem nicht-keramischen Kernkörper (60) der Transferwalze (26) eine keramische Hülse angeordnet ist.

7. Applikationsvorrichtung (18) nach einem der vorhergehenden Ansprüche, **dadurch gekennzeichnet, dass** die Transferwalze (26) und die Druckwalze (28) in Kontakt stehen und ein zwischen der Transferwalze (26) und der Druckwalze (28) herrschender Druck mittels zumindest eines Servomotors (29) variabel einstellbar ist.

8. Beschichtungsanlage (10) zum Bedampfen von Folien mit Metalldampf zur Ausbildung einer metallischen Schicht (68, 70), mit einer Applikationsvorrichtung (18) gemäß einem der vorhergehenden Ansprüche, einer Fördereinrichtung (12) zum Fördern einer Folienbahn (14) durch die Vakuumkammer (34) und einer Bedampfungseinrichtung (16) zum Bedampfen der Folie mit Metalldampf zur Ausbildung von metallischen Schichten (68, 70), die in der Vakuumkammer (34) angeordnet ist.

9. Verfahren zum Bedampfen einer Folie mit Metalldampf zur Ausbildung von metallischen Schichten (68, 70) in einer Beschichtungsanlage (10), umfassend die folgenden Schritte:
- In einem Verdampfer (32) wird ein Maskierungsfluid erhitzt, wodurch ein Maskierungsfluiddampf erzeugt wird, der sich an einer Transferwalze (26) innerhalb einer Vakuumkammer (34) absetzt, während die Transferwalze (26) rotiert, wobei die Menge des Maskierungsfluiddampfs entlang der Längsachse der Transferwalze (26) unterschiedlich dosiert wird, sodass sich auf der Transferwalze (26) lokal unterschiedlich dicke Schichten des Maskierungsfluids absetzen,
- die Schicht des Maskierungsfluids wird von der Transferwalze (26) zunächst auf eine mit der Transferwalze (26) in Kontakt stehende und rotierende Druckwalze (28) und in der Vakuumkammer (34) von der Druckwalze (28) entsprechend einem durch eine auf der Druckwalze (28) vorgesehene Druckform (30) definierten Druckmuster auf eine durch die Vakuumkammer (34) der Beschichtungsanlage laufende Folienbahn (14) übertragen, wobei sich auf der Folienbahn (14) entsprechend der Dosierung zumindest ein erster Bereich (64) und ein zweiter Bereich (66) ergibt, wobei die Schicht des Maskierungsfluids im ersten Bereich (64) dünner ist als im zweiten Bereich (66),
- in dem ersten Bereich (64) und in dem zweiten Bereich (66) wird jeweils zumindest eine metallische Schicht (68, 70) durch Bedampfen in der Vakuumkammer (34) aufgebracht, wobei die metallische Schicht (68, 70) in dem ersten Bereich (64) dünner ist als in dem zweiten Bereich (66), und
- wobei die Schicht des Maskierungsfluids in einem Bereich (64, 66) in dem Moment vollständig oder nahezu vollständig verdampft ist, in dem die metallische Schicht (68, 70) in dem entsprechenden Bereich vollständig aufgebracht ist.

10. Verfahren nach Anspruch 9, **dadurch gekennzeichnet, dass** der erzeugte Maskierungsfluiddampf durch eine Maske (48) entweicht, die einer Austrittsöffnung (44) des Verdampfers (32) zugeordnet ist, insbesondere wobei sich in den Bereichen, in denen eine entlang der Transferwalze (26) verlaufende Öffnung (50) der Maske (48) eine größere Breite hat, eine dickere Schicht des Maskierungsfluids auf der Transferwalze (26) absetzt, als in den Bereichen, in denen die Öffnung (50) der Maske (48) eine geringere Breite hat.

11. Verfahren nach Anspruch 9 oder 10, **dadurch gekennzeichnet, dass** das Maskierungsfluid ein Öl ist, insbesondere ein PFPE-ÖI.

12. Verfahren nach einem der Ansprüche 9 bis 11, **dadurch gekennzeichnet, dass** die erste metallische Schicht (68, 70) und die zweite metallische Schicht (68, 70) ineinander übergehen.

13. Verfahren nach einem der Ansprüche 9 bis 12, **dadurch gekennzeichnet, dass** die metallische Schicht (70) im zweiten Bereich einen verstärkten Randbereich auf einer Folienbahn (14) abbildet.

14. Verfahren nach einem der Ansprüche 9 bis 13, **dadurch gekennzeichnet, dass** die metallische Schicht (68) in dem ersten Bereich voneinander getrennte Felder (72) aufweist, die jeweils durch einen Steg (74) miteinander verbunden sind.

15. Wickelkondensator, der durch Aufwickeln einer gemäß den Ansprüchen 9 bis 14 beschichteten Folienbahn (14) gebildet ist, wobei die metallische Schicht (68) im ersten Bereich (64) einen aktiven Bereich des Kondensators bildet und die metallische Schicht (70) im zweiten Bereich (66) einen elektrischen Anschluss bildet.

16. Verwendung einer Transferwalze (26) in einer Beschichtungsanlage (10) zum Bedampfen von Folien mit Metalldampf zur Ausbildung einer metallischen Schicht (68, 70), wobei die Beschichtungsanlage (10) eine Applikationsvorrichtung (18) aufweist, die eine Vakuumkammer (34) aufweist und eingerichtet ist, ein Maskierungsfluid, beispielsweise ein Öl, auf die zu bedampfende Folie in der Vakuumkammer (34) aufzubringen, wobei die Applikationsvorrichtung (18) einen Verdampfer (32) für das Maskierungsfluid umfasst, der eingerichtet ist, einen Maskierungsfluiddampf zu erzeugen, der sich auf der Transferwalze (26) absetzt, wobei die Applikationsvorrichtung (18) eine Druckwalze (28) umfasst, die in der Vakuumkammer (34) angeordnet ist, wobei auf der Druckwalze (28) eine mit der Transferwalze (26) in Kontakt stehende Druckform (30) angeordnet ist, und wobei die Beschichtungsanlage (10) eine Fördereinrichtung (12) zum Fördern einer Folienbahn (14) durch eine Vakuumkammer (34) der Applikationsvorrichtung (18) und eine Bedampfungseinrichtung (16) umfasst, die zum Bedampfen der Folie mit Metalldampf zur Ausbildung von metallischen Schichten (68, 70) vorgesehen ist, die in der Vakuumkammer (34) angeordnet ist, wobei die Transferwalze (26) eine keramische Oberfläche hat, die geschliffen ist, sodass die Transferwalze eine Rauigkeit Rz von 1,0 bis 1,5 µm hat.
